# EUROPEAN PATENT APPLICATION

(11) **EP 4 564 437 A1**
(43) Date of publication of application: **04.06.2025**
(21) Application number: 23846119.8
(22) Date of filing: 29.06.2023
(51) Int. Cl.: H01L 29/78, H01L 21/336, H01L 29/06, H01L 29/12, H01L 29/739

(54) **SEMICONDUCTOR DEVICE AND METHOD FOR MANUFACTURING SEMICONDUCTOR DEVICE**

(30) Priority: 29.07.2022 JP 2022122100
(71) Applicant: SHI-ATEX Co., Ltd., Saijo-shi, Ehime 799-1393 (JP)
(72) Inventor: SAKANE, Hitoshi, Saijo-shi, Ehime 799-1393 (JP); KATO, Masashi, Nagoya-shi Aichi 466-8555 (JP); HARADA, Shunta, Nagoya-shi Aichi 464-8601 (JP)
(74) Representative: Louis Pöhlau Lohrentz
(86) International application number: PCT/JP2023/024274
(87) International publication number: WO 2024/024386

(57) **Abstract**

A semiconductor device 10 includes a substrate 12 formed of silicon carbide and a semiconductor layer of a first conductivity type provided on a first surface 12a of the substrate 12. By irradiation with hydrogen ions, a high concentration hydrogen region 40 having a hydrogen concentration of higher than 10¹⁵/cm³ is formed over a thickness of 1 µm or more. At least a part of the high concentration hydrogen region 40 is formed in the semiconductor layer of the first conductivity type.

## Description

### Technical Field

The present invention relates to a semiconductor device and a method for manufacturing a semiconductor device.

### Background Art

Silicon carbide (SiC) has attracted attention as a material used for the next-generation power semiconductor device. For example, an epitaxial layer is formed on a SiC substrate, and a transistor structure is formed in the epitaxial layer. In the SiC semiconductor device, it is known that an implanted carrier is trapped in a stacking fault in the epitaxial layer during current application, and the stacking fault energy decreases, which leads to expansion of the stacking fault. The expansion of the stacking fault leads to an increase in forward voltage, which causes a problem.

In order to suppress the expansion of the stacking fault, there is disclosed a technique of irradiating the inside of the epitaxial layer with protons to generate a lifetime killer such that recombination of the carrier is promoted before the implanted carrier is trapped in the stacking fault.

### Citation List

### Patent Literature

[PTL 1] Japanese Unexamined Patent Publication No. 2019-102493

### Summary of Invention

### Technical Problem

When the lifetime killer is generated to suppress the expansion of the stacking fault, the lifetime killer needs to be generated in a wide range in a depth direction to promote the sufficient recombination of the carrier. It is necessary to increase the film thickness of the epitaxial layer or to irradiate a wide range in the depth direction with protons, which leads to an increase in manufacturing cost.

One exemplary object of one aspect of the present invention is to provide a technique of suppressing expansion of a stacking fault during current application of a SiC semiconductor device.

### Solution to Problem

According to one aspect of the present invention, there is provided a method for manufacturing a semiconductor device including a substrate formed of silicon carbide and a first conductivity type semiconductor layer provided on a first surface of the substrate, the method including irradiating the semiconductor device with hydrogen ions to form a high concentration hydrogen region having a hydrogen concentration of higher than 10¹⁵/cm³ over a thickness of 1 µm or more. At least a part of the high concentration hydrogen region is formed in the semiconductor layer of the first conductivity type.

Another aspect of the present invention is a semiconductor device. This semiconductor device includes: a substrate formed of silicon carbide; a semiconductor layer of a first conductivity type provided on the substrate; and a high concentration hydrogen region having a hydrogen concentration of higher than 10¹⁵/cm³ over a thickness of 1 µm or more. At least a part of the high concentration hydrogen region is formed in the semiconductor layer of the first conductivity type.

Any combination of the components described above and a combination obtained by switching the components and expressions of the present invention between methods, devices, and systems are also effective as an embodiment of the present invention.

### Advantageous Effects of Invention

According to one aspect of the present invention, expansion of a stacking fault during current application to a SiC semiconductor device can be suppressed.

### Brief Description of Drawings

Fig. 1 is a cross-sectional view schematically showing a configuration example of a semiconductor device according to an embodiment.
Fig. 2 is a graph showing an example of a hydrogen concentration of the semiconductor device after irradiation with hydrogen ions.
Fig. 3 is a table showing a thickness of a high concentration hydrogen region and whether expansion of a stacking fault occurs in Comparative Example and Example.
Figs. 4A to 4D are diagrams schematically showing another example of a formation position of the high concentration hydrogen region.
Fig. 5 is a cross-sectional view schematically showing a manufacturing step of the semiconductor device.
Fig. 6 is a cross-sectional view schematically showing a manufacturing step of the semiconductor device.
Fig. 7 is a cross-sectional view schematically showing a manufacturing step of the semiconductor device.
Fig. 8 is a cross-sectional view schematically showing a manufacturing step of the semiconductor device.
Fig. 9 is a cross-sectional view schematically showing a manufacturing step of the semiconductor device.
Fig. 10 is a cross-sectional view schematically showing a manufacturing step of the semiconductor device.
Fig. 11 is a cross-sectional view schematically showing a manufacturing step of the semiconductor device.
Fig. 12 is a flowchart showing an example of a method for manufacturing the semiconductor device according to the embodiment.

### Description of Embodiments

Hereinafter, an embodiment for carrying out the present invention will be described in detail. Configurations to be described below are merely examples and do not limit the scope of the present invention. In addition, in the description of the drawings, the same elements will be assigned with the same reference signs, and redundant description will be omitted as appropriate. In addition, in the drawings referred to in the following description, sizes and thicknesses of the respective components are for convenience of description and do not necessarily indicate actual dimensions or proportions.

The summary of the present embodiment will be described. The present embodiment relates to a SiC semiconductor device including: a substrate formed of silicon carbide (SiC); and a semiconductor layer of a first conductivity type provided on a first surface of the substrate. In this SiC semiconductor device, there is a problem in that a stacking fault present in the vicinity of an interface between the substrate and the semiconductor layer expands during current application, which leads to an increase in forward voltage.

In the present embodiment, the vicinity of the interface between the substrate and the semiconductor layer is irradiated with hydrogen ions to fix hydrogen to partial dislocation that fringes the stacking fault such that the expansion of the stacking fault during current application is suppressed. By fixing hydrogen to the partial dislocation, an implanted carrier is trapped in the stacking fault, and a decrease in stacking fault energy can be suppressed.

According to the finding of the present inventors, the expansion of the stacking fault can be suppressed by forming a high concentration hydrogen region having a hydrogen concentration of higher than 10¹⁵/cm³ over a thickness of 1 µm or more by irradiation with hydrogen ions. By forming the high concentration hydrogen region over the thickness of 1 µm or more, a sufficient amount of hydrogen can be fixed to the partial dislocation that fringes the stacking fault present in the vicinity of the interface between the substrate and the semiconductor layer, and the expansion of the stacking fault can be suitably suppressed.

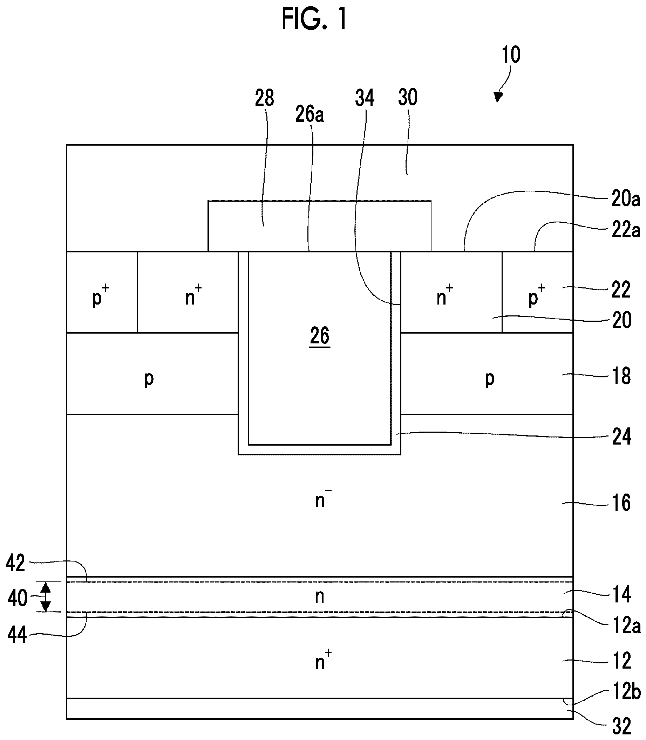

Fig. 1 is a cross-sectional view schematically showing a configuration example of a semiconductor device 10 according to an embodiment. The semiconductor device 10 is a SiC semiconductor device and is a metal-oxide-semiconductor field-effect transistor (MOSFET). The semiconductor device 10 includes a substrate 12, a buffer layer 14, a drift layer 16, a base region 18, a source region 20, a base contact region 22, a gate insulating film 24, a gate electrode 26, an interlayer dielectric 28, a source electrode 30, and a drain electrode 32.

The substrate 12 is a SiC substrate formed of silicon carbide (SiC) of a first conductivity type (for example, n-type) or a second conductivity type (for example, p-type). The substrate 12 is, for example, an n-type SiC substrate and is doped with, for example, nitrogen (N) as an n-type impurity. The impurity concentration of the first conductivity type or the second conductivity type in the substrate 12 is 1.0 × 10¹⁸/cm³ or higher, for example, 2.0 × 10¹⁸/cm³ or higher and 5.0 × 10¹⁹/cm³ or lower. The substrate 12 includes a first surface 12a and a second surface 12b opposite to the first surface 12a. The first surface 12a is, for example, a (0001) Si surface.

The buffer layer 14 is a SiC semiconductor layer of the first conductivity type that is epitaxially grown on the first surface 12a of the substrate 12. The buffer layer 14 is, for example, an n-type SiC layer and is doped with, for example, nitrogen (N) as an n-type impurity. The impurity concentration of the first conductivity type in the buffer layer 14 is lower than the impurity concentration of the first conductivity type or the second conductivity type in the substrate 12 and is higher than the impurity concentration of the first conductivity type in the drift layer 16. The impurity concentration of the first conductivity type in the buffer layer 14 is 1.0 × 10¹⁶/cm³ or higher and 1.0 × 10¹⁸/cm³ or lower. The thickness of the buffer layer 14 is 1.0 µm or more and 5.0 µm or less, for example, 1.5 µm or more and 3.0 µm or less or 2.0 µm.

The drift layer 16 is a SiC semiconductor layer of the first conductivity type that is epitaxially grown on the buffer layer 14. The drift layer 16 is, for example, an n-type SiC layer and is doped with, for example, nitrogen (N) as an n-type impurity. The impurity concentration of the first conductivity type in the drift layer 16 is lower than the impurity concentration of the first conductivity type in the buffer layer 14. The impurity concentration of the first conductivity type in the drift layer 16 is 1.0 × 10¹⁵/cm³ or higher and 1.0 × 10¹⁷/cm³ or lower. The thickness of the drift layer 16 is more than the thickness of the buffer layer 14. The thickness of the drift layer 16 is 5.0 µm or more and 50 µm or less, for example, 7.5 µm or more and 15 µm or less or 10 µm.

The base region 18 is a SiC semiconductor region of the second conductivity type provided on the drift layer 16. The base region 18 is, for example, a p-type and is doped with, for example, aluminum (Al) as a p-type impurity. The base region 18 is formed, for example, by irradiating the drift layer 16 with impurity ions of the second conductivity type. The impurity concentration of the second conductivity type in the base region 18 is higher than the impurity concentration of the first conductivity type in the drift layer 16. The impurity concentration of the second conductivity type in the base region 18 is 1.0 × 10¹⁶/cm³ or higher and 1.0 × 10¹⁸/cm³ or lower.

The source region 20 is a SiC semiconductor region of the first conductivity type provided on the base region 18. The source region 20 is provided adjacent to the gate insulating film 24. The source region 20 is, for example, an n-type and is doped with, for example, nitrogen (N) as an n-type impurity. The source region 20 is formed, for example, by irradiating the drift layer 16 with impurity ions of the first conductivity type. The impurity concentration of the first conductivity type in the source region 20 is higher than that in the drift layer 16. The impurity concentration of the first conductivity type in the source region 20 is 1.0 × 10¹⁸/cm³ or higher, for example, 2.0 × 10¹⁸/cm³ or higher and 5.0 × 10¹⁹/cm³ or lower.

The base contact region 22 is a SiC semiconductor region of the second conductivity type provided on the base region 18. The base contact region 22 is provided distant from the gate insulating film 24. The base contact region 22 is, for example, a p-type and is doped with, for example, aluminum (Al) as a p-type impurity. The base contact region 22 is formed, for example, by irradiating the drift layer 16 with impurity ions of the second conductivity type. The impurity concentration of the second conductivity type in the base contact region 22 is higher than the impurity concentration of the second conductivity type in the base region 18. The impurity concentration of the second conductivity type in the base contact region 22 is 1.0 × 10¹⁷/cm³ or higher and 1.0 × 10¹⁹/cm³ or lower.

The gate insulating film 24 is provided on an inner wall surface of a gate trench 34. The gate insulating film 24 is provided adjacent to the drift layer 16, the base region 18, and the source region 20. The gate trench 34 is formed to be dug into the substrate 12 from an upper surface 20a of the source region 20. The gate trench 34 is formed to penetrate the source region 20 and the base region 18 and to reach an upper portion of the drift layer 16. The gate insulating film 24 is formed of an oxide material, for example, SiO₂.

The gate electrode 26 is provided to be embedded in the gate insulating film 24 (gate trench 34). The gate electrode 26 is formed of polycrystal silicon doped with an n-type impurity such as phosphorus (P) or nitrogen (N).

The interlayer dielectric 28 is provided on the gate insulating film 24 and the gate electrode 26. The interlayer dielectric 28 is formed of any insulating material.

The source electrode 30 is provided on the source region 20, the base contact region 22, and the interlayer dielectric 28. The source electrode 30 is in contact with the upper surface 20a of the source region 20 and an upper surface 22a of the base contact region 22. The source electrode 30 is formed of, for example, a metal material such as chromium (Cr) or a nickel (Ni) . The source electrode 30 may be formed of a metal multilayer film where a plurality of metal layers of different metal materials are stacked. The source electrode 30 is a front surface metal electrode layer formed on a front surface of the semiconductor device 10.

The drain electrode 32 is provided on the second surface 12b of the substrate 12. The drain electrode 32 is in contact with the second surface 12b of the substrate 12. The drain electrode 32 is formed of, for example, a metal material such as chromium (Cr) or a nickel (Ni). The drain electrode 32 may be formed of a metal multilayer film where a plurality of metal layers of different metal materials are stacked. The drain electrode 32 is a back surface metal electrode layer formed on a back surface of the semiconductor device 10.

In a manufacturing step of the semiconductor device 10, the semiconductor device 10 is irradiated with hydrogen ions to form a high concentration hydrogen region 40 having a hydrogen concentration of higher than 10¹⁵/cm³ over a thickness of 1 µm or more. At least a part of the high concentration hydrogen region 40 is formed in the buffer layer 14 or the drift layer 16 that is the semiconductor layer of the first conductivity type. In the example of Fig. 1, the entirety of the high concentration hydrogen region 40 is formed in the buffer layer 14, and an upper end 42 and a lower end 44 of the high concentration hydrogen region 40 are positioned in the buffer layer 14.

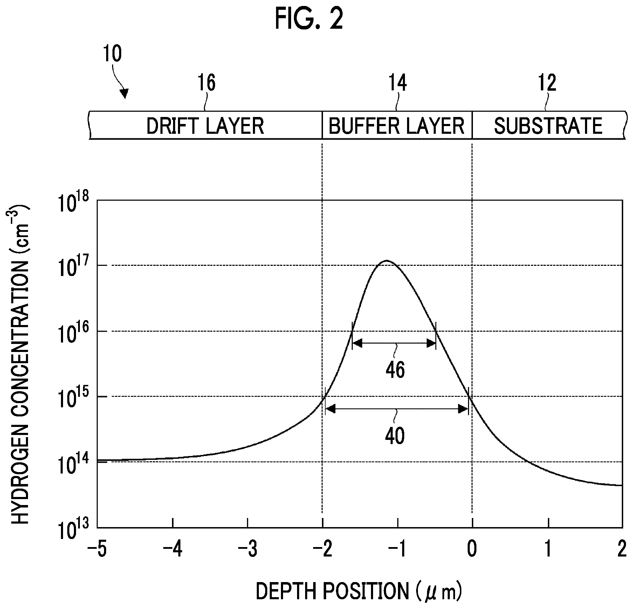

Fig. 2 is a graph showing an example of a hydrogen concentration of the semiconductor device 10 after irradiation with hydrogen ions. Fig. 2 shows a case where the energy of the hydrogen ion irradiation is 960 keV and the dose is 1.0 × 10¹³/cm². In the example of Fig. 2, the thickness range of the high concentration hydrogen region 40 having a hydrogen concentration of higher than 10¹⁵/cm³ is about 1.9 µm. In the example of Fig. 2, in the high concentration hydrogen region 40, the hydrogen concentration in a thickness range 46 of 1.1 µm is higher than 10¹⁶/cm³. In the example of Fig. 2, a peak value of the hydrogen concentration in the high concentration hydrogen region 40 is about 1.1 × 10¹⁷/cm³. By forming the high concentration hydrogen region 40 in the buffer layer 14, the expansion of the stacking fault during current application to the semiconductor device 10 can be suppressed.

Whether the expansion of the stacking fault occurs can be checked by X-ray topography or photoluminescence. First, a position of the stacking fault present in the semiconductor device 10 before current application can be checked by X-ray topography or photoluminescence, and whether the stacking fault expands after current application can be observed by X-ray topography or photoluminescence. Instead of generating an implanted carrier by current application, a carrier can also be generated by irradiation with ultraviolet light to check whether the expansion of the stacking fault occurs.

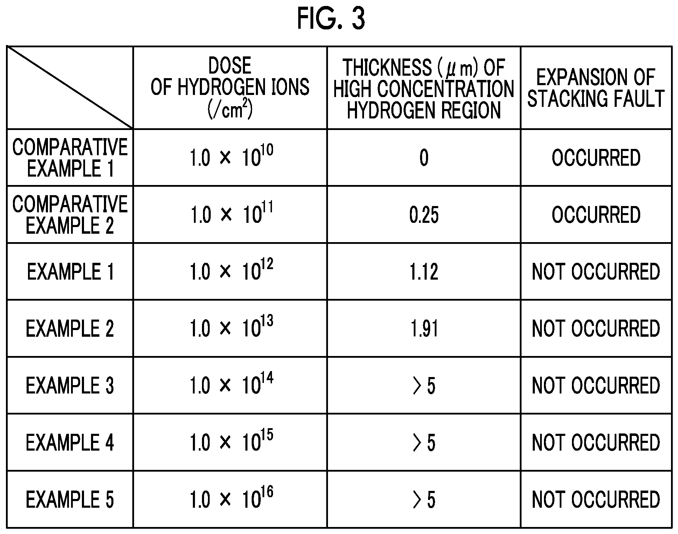

Fig. 3 is a table showing the thickness of the high concentration hydrogen region 40 and whether the expansion of the stacking fault occurs in Comparative Example and Example. Fig. 3 collectively shows the results of whether the expansion of the stacking fault occurred when the dose of the irradiation with the hydrogen ions was changed in a range of 1.0 × 10¹⁰/cm² to 1.0 x 10¹⁶/cm². In Comparative Examples 1 and 2 where the thickness of the high concentration hydrogen region 40 was less than 1 µm, the expansion of the stacking fault was checked. On the other hand, in Examples 1 to 5 where the thickness of the high concentration hydrogen region 40 was 1 µm or more, the expansion of the stacking fault was not checked. Therefore, it was found that the expansion of the stacking fault was able to be suppressed.

It is considered that, even when the dose is higher than 1.0 × 10¹⁶/cm², the expansion of the stacking fault can be suppressed. However, it is not preferable that the dose is higher than 1.0 × 10¹⁶/cm² from the viewpoint of productivity.

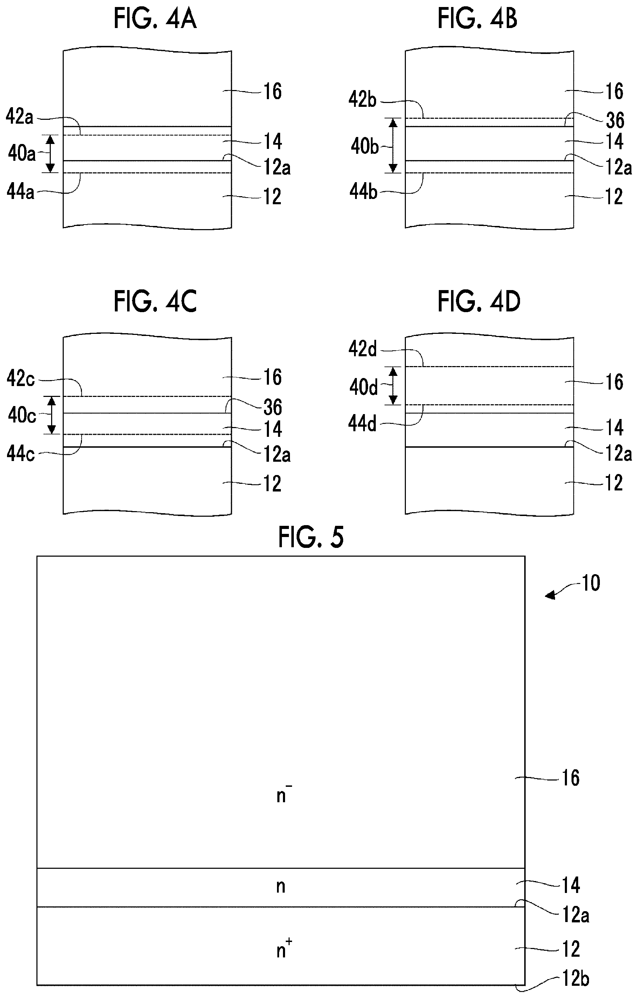

Figs. 4A to 4D are diagrams schematically showing other examples of formation positions of high concentration hydrogen regions 40a to 40d.

The high concentration hydrogen region 40a shown in **Fig.** 4A is formed across the substrate 12 and the buffer layer 14, and is formed across the first surface 12a that is the interface between the substrate 12 and the buffer layer 14. An upper end 42a of the high concentration hydrogen region 40a is positioned in the buffer layer 14, and a lower end 44a of the high concentration hydrogen region 40a is positioned in the substrate 12. At least a part of the high concentration hydrogen region 40a is formed in the substrate 12 and the buffer layer 14.

The high concentration hydrogen region 40b shown in Fig. 4B is formed across the substrate 12, the buffer layer 14, and the drift layer 16. The high concentration hydrogen region 40b is formed across the first surface 12a that is the interface between the substrate 12 and the buffer layer 14, and is formed across an interface 36 between the buffer layer 14 and the drift layer 16. An upper end 42b of the high concentration hydrogen region 40b is positioned in the drift layer 16, and a lower end 44b of the high concentration hydrogen region 40b is positioned in the substrate 12. At least a part of the high concentration hydrogen region 40b is formed in the substrate 12, the buffer layer 14, and the drift layer 16.

The high concentration hydrogen region 40c shown in Fig. 4C is formed across the buffer layer 14 and the drift layer 16. The high concentration hydrogen region 40c is formed across an interface 36 between the buffer layer 14 and the drift layer 16. An upper end 42c of the high concentration hydrogen region 40c is positioned in the drift layer 16, and a lower end 44c of the high concentration hydrogen region 40c is positioned in the buffer layer 14. At least a part of the high concentration hydrogen region 40b is formed in the buffer layer 14 and the drift layer 16.

The high concentration hydrogen region 40d shown in Fig. 4D is formed only in the drift layer 16. An upper end 42d and a lower end 44d of the high concentration hydrogen region 40d are positioned in the drift layer 16.

It is preferable that the high concentration hydrogen regions 40 and 40a to 40d are formed at a position close to the first surface 12a of the substrate 12. It is preferable that at least a part of the high concentration hydrogen regions 40 and 40a to 40d is formed within 5 µm from the first surface 12a of the substrate 12. It is preferable that the upper ends 42 and 42a to 42d or the lower ends 44 and 44a to 44d of the high concentration hydrogen regions 40 and 40a to 40d are positioned within 5 µm from the first surface 12a of the substrate 12. The upper ends 42 and 42a to 42d or the lower ends 44 and 44a to 44d of the high concentration hydrogen regions 40 and 40a to 40d may be formed within 4 µm, 3 µm, or 2 µm from the first surface 12a of the substrate 12.

The hydrogen concentration in the high concentration hydrogen regions 40 and 40a to 40d may decrease afterwards by an annealing treatment in the manufacturing steps of the semiconductor device 10. For example, when the annealing treatment is executed after the irradiation with hydrogen ions, hydrogen is diffused in the annealing treatment such that the hydrogen concentration may decrease. At this time, hydrogen fixed to the partial dislocation that fringes the stacking fault is maintained in the fixed state even after the annealing treatment. That is, hydrogen that is diffused in the annealing treatment is not fixed to the partial dislocation that fringes the stacking fault and does not contribute to the suppression of the expansion of the stacking fault. In the present embodiment, even when the hydrogen concentration in the buffer layer 14 or the drift layer 16 at the time of completion of the semiconductor device 10 is 1.0 × 10¹⁵/cm² or lower, the expansion of the stacking fault can be suppressed as long as the hydrogen concentration in the buffer layer 14 or the drift layer 16 after the irradiation with the hydrogen ions is higher than 1.0 × 10¹⁵/cm² over the thickness of 1 µm or more.

When the annealing treatment is not executed after the irradiation with the hydrogen ions, the state where the hydrogen concentration in the buffer layer 14 or the drift layer 16 of the semiconductor device 10 is higher than 1.0 × 10¹⁵/cm² may be maintained. In this case, since the high concentration hydrogen regions 40 and 40a to 40d are formed by the irradiation with the hydrogen ions, the expansion of the stacking fault can be suppressed.

Next, a method for manufacturing the semiconductor device 10 will be described. Figs. 5 to 11 are cross-sectional views schematically showing the manufacturing steps of the semiconductor device.

First, as shown in Fig. 5, the buffer layer 14 is formed on the first surface 12a of the substrate 12, and the drift layer 16 is formed on the buffer layer 14. The buffer layer 14 and the drift layer 16 are formed using any epitaxial growth method such as chemical vapor deposition (CVD). A growth temperature of the buffer layer 14 and the drift layer 16 is, for example, 1500°C or higher and 1700°C or lower.

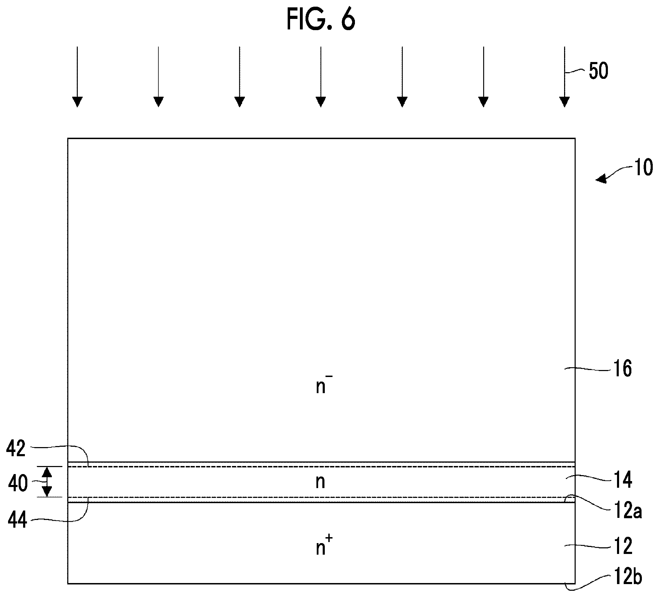

Next, as shown in Fig. 6, the semiconductor device 10 is irradiated with hydrogen ions 50 from above the drift layer 16 to form the high concentration hydrogen region 40 in the buffer layer 14. The irradiation with the hydrogen ions 50 can be executed using any ion irradiation device. For example, the semiconductor device 10 can be irradiated with the hydrogen ions 50 using a cyclotron type or Van de Graaff type ion irradiation device. The semiconductor device 10 may be irradiated with the hydrogen ions 50 from the second surface 12b (back surface) of the substrate 12.

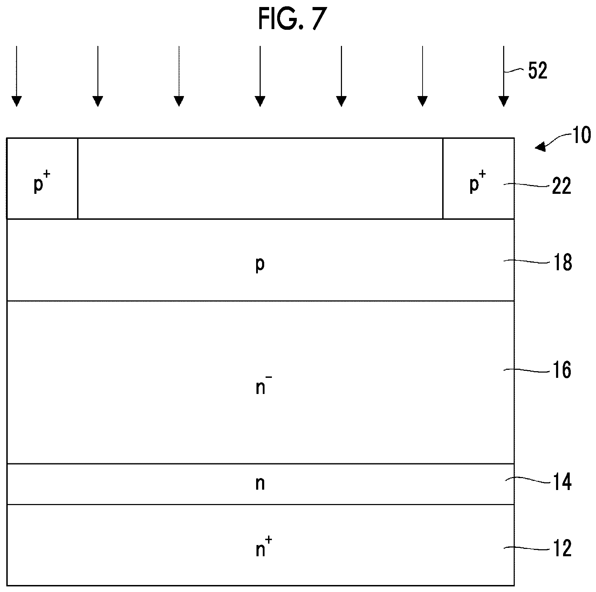

Next, as shown in Fig. 7, the semiconductor device 10 is irradiated with second impurity ions 52 as an impurity of the second conductivity type from above the drift layer 16 to form the base region 18 and the base contact region 22. The second impurity ions 52 are, for example, aluminum ions. The base region 18 can be formed by irradiating the entire surface of the drift layer 16 with the second impurity ions 52. The base contact region 22 can be formed by irradiating the semiconductor device 10 with the second impurity ions 52 in a state where regions other than a region where the base contact region 22 is to be formed are masked.

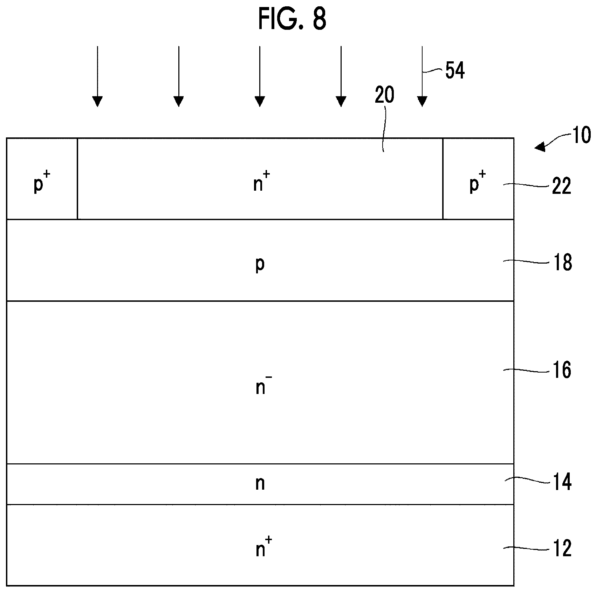

Next, as shown in Fig. 8, the semiconductor device 10 is irradiated with first impurity ions 54 as an impurity of the first conductivity type from above the drift layer 16 to form the source region 20. The first impurity ions 54 are, for example, nitrogen ions. The source region 20 can be formed by irradiating the semiconductor device 10 with the first impurity ions 54 in a state where regions (for example, the base contact region 22) other than a region where the source region 20 is to be formed are masked.

Next, the annealing treatment is executed at a first temperature to activate the impurity of the first conductivity type or the second conductivity type implanted into the base region 18, the source region 20, and the base contact region 22. The first temperature is 1500°C or higher, for example, 1600°C or higher and 1800°C or lower. By executing the annealing treatment at the first temperature, a lattice defect formed on the buffer layer 14 by the irradiation with the hydrogen ions 50 can be recovered. In addition, by executing the annealing treatment at the first temperature, hydrogen not fixed to partial dislocation that fringes an expansion defect can be diffused to decrease the hydrogen concentration in the high concentration hydrogen region 40 to be 1 × 10¹⁵/cm³ or lower.

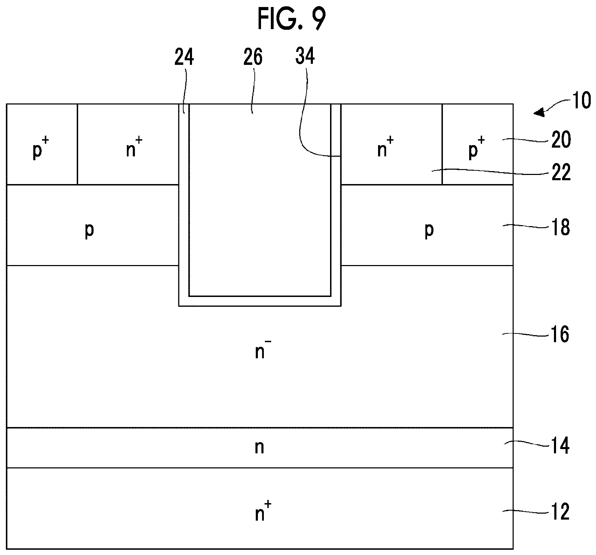

Next, as shown in Fig. 9, the gate trench 34 is formed. For example, by masking regions other than a region where the gate trench 34 is to be formed and dry-etching the source region 20, the base region 18, and the drift layer 16 in an opening region of the mask, the gate trench 34 can be formed.

Next, the gate insulating film 24 is formed on the inner wall surface of the gate trench 34. The gate insulating film 24 can be formed, for example, by thermally oxidizing the inner wall surface of the gate trench 34 at a temperature of about 700°C to 1000°C. Next, the gate electrode 26 is formed in the gate insulating film 24. The gate electrode 26 can be formed using any technique such as CVD.

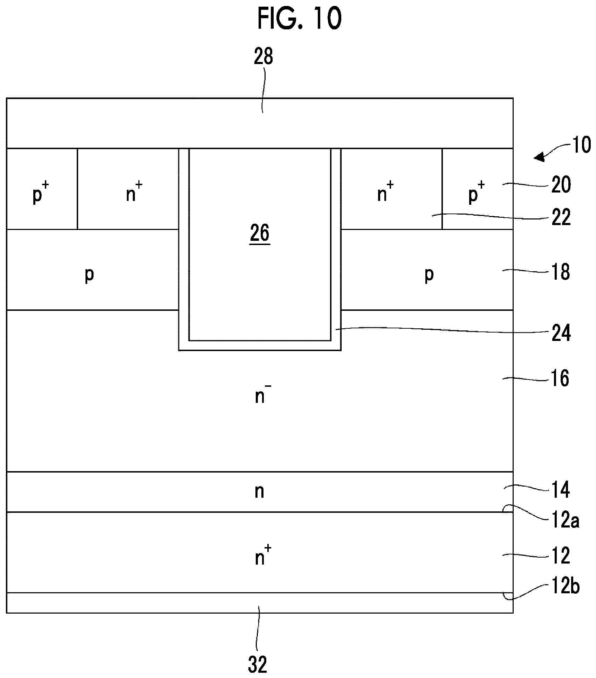

Next, as shown in Fig. 10, the interlayer dielectric 28 is formed on the source region 20, the base contact region 22, the gate insulating film 24, and the gate electrode 26. The interlayer dielectric 28 can be formed using any technique such as CVD. Next, the drain electrode 32 (back surface metal electrode layer) is formed on the second surface 12b of the substrate 12. The drain electrode 32 can be formed using any film forming technique such as sputtering or vapor deposition.

After the formation of the drain electrode 32, the drain electrode 32 is annealed at a second temperature such that the drain electrode 32 is in ohmic contact with the second surface 12b of the substrate 12. The second temperature is 450°C or higher, for example, 600°C or higher and 800°C or lower.

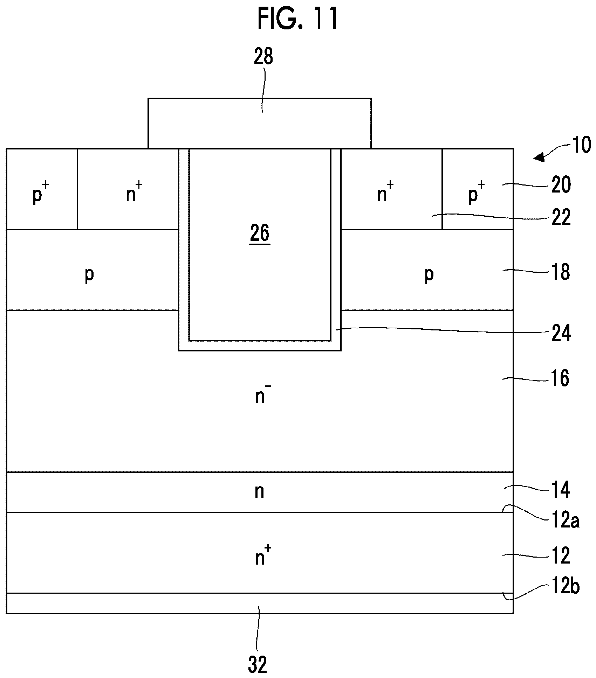

Next, as shown in Fig. 11, a part of the interlayer dielectric 28 is removed to expose the upper surface 20a of the source region 20 and the upper surface 22a of the base contact region 22. Next, the source electrode 30 (front surface metal electrode layer) shown in Fig. 1 is formed. The source electrode 30 can be formed using any film forming technique such as sputtering or vapor deposition.

After the formation of the source electrode 30, the source electrode 30 is annealed at a third temperature such that the source electrode 30 is in ohmic contact with the source region 20 and the base contact region 22. The third temperature is 300°C or higher, for example, 350°C or higher and 500°C or lower.

Through the above-described steps, the semiconductor device 10 of Fig. 1 can be formed.

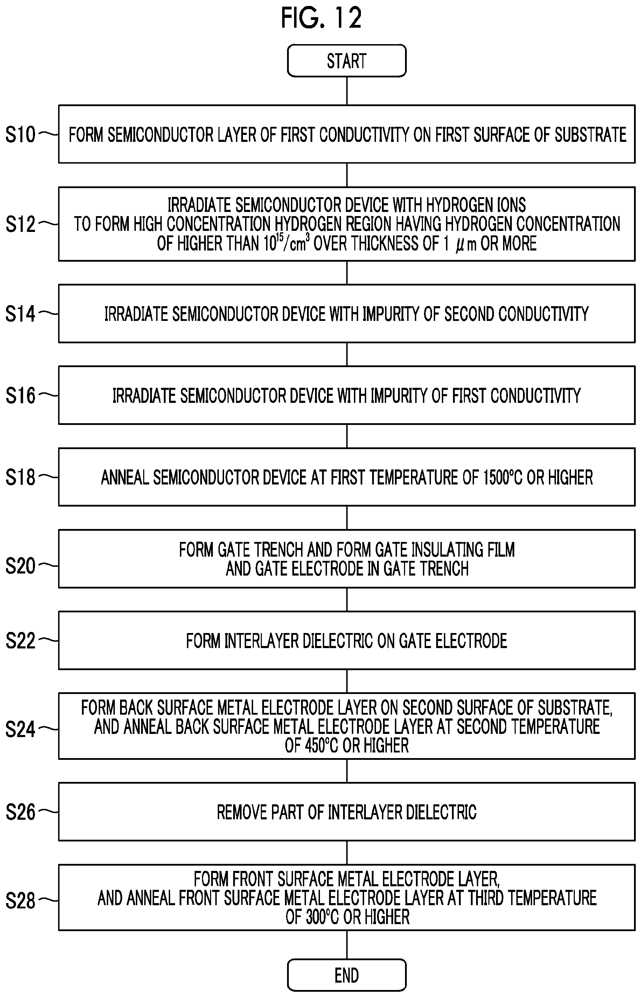

Fig. 12 is a flowchart showing an example of the method for manufacturing the semiconductor device 10 according to the embodiment. First, the semiconductor layer of the first conductivity type (for example, the buffer layer 14 and the drift layer 16) is formed on the first surface 12a of the substrate 12 (S10). Next, the semiconductor device 10 is irradiated with the hydrogen ions 50 to form the high concentration hydrogen region 40 having a hydrogen concentration of higher than 10¹⁵/cm³ over a thickness of 1 µm or more (S12). The semiconductor device 10 is irradiated with the impurity ions 52 of the second conductivity type to form the base region 18 and the base contact region 22 (S14), and is irradiated with the impurity ions 54 of the first conductivity type to form the source region 20 (S16) .

Next, the semiconductor device 10 is annealed at the first temperature of 1500°C or higher (S18) to activate the impurities of the base region 18, the source region 20, and the base contact region 22. Next, the gate trench 34 is formed, and the gate insulating film 24 and the gate electrode 26 are formed in the gate trench 34 (S20). Next, the interlayer dielectric 28 is formed on the gate electrode 26 (S22).

Next, the back surface metal electrode layer (drain electrode 32) is formed on the second surface 12b of the substrate 12, and is annealed at the second temperature of 450°C or higher (S24). Next, a part of the interlayer dielectric 28 is removed (S26) to form the front surface metal electrode layer (source electrode 30) on the interlayer dielectric 28, and the front surface metal electrode layer is annealed at the third temperature of 300°C or higher (S28).

In the present embodiment, by irradiating the semiconductor device 10 with the hydrogen ions 50 to form the high concentration hydrogen region 40 having a hydrogen concentration of higher than 10¹⁵/cm³ over a thickness of 1 µm or more, the expansion of the stacking fault can be suppressed. In particular, the upward expansion of the stacking fault present in the buffer layer 14 or the drift layer 16 can be suppressed, and the reaching of the stacking fault to the base region 18, the source region 20, and the base contact region 22 can be suppressed. As a result, a decrease in performance caused by the energization and use of the semiconductor device 10 can be suppressed.

In the present embodiment, by executing the annealing treatment at the first temperature of 1500°C or higher after the irradiation with the hydrogen ions 50, a lattice defect formed on the buffer layer 14 or the drift layer 16 by the irradiation with the hydrogen ions 50 can be recovered. As a result, a decrease in the lifetime of the carrier caused by the lattice defect can be suppressed, and the effect on device characteristics can be suppressed.

In the flow of Fig. 12, the order of the steps S12 to S16 may be reversed. For example, the irradiation with the hydrogen ions 50 in S12 may be executed after the irradiation with the second impurity ions 52 in S14, or the irradiation with the hydrogen ions 50 in S12 may be executed after the irradiation with the first impurity ions 54 in S16. In addition, the irradiation with the second impurity ions 52 in S14 may be executed after the irradiation with the first impurity ions 54 in S16.

In the flow of Fig. 12, the irradiation with the hydrogen ions 50 in S12 may be executed after the annealing treatment at the first temperature in S18. In this case, by executing the annealing treatment at the second temperature in S24, a lattice defect formed by the irradiation with the hydrogen ions 50 can be recovered. The irradiation step of the hydrogen ions 50 in S12 may be executed between S18 and S20, may be executed between S20 and S22, or may be executed between S22 and S24.

In the flow of Fig. 12, the irradiation with the hydrogen ions 50 in S12 may be executed after the annealing treatment at the second temperature in S24. In this case, the irradiation step of the hydrogen ions 50 in S12 may be executed between S24 and S26, or may be executed between S26 and S28. In this case, since the third temperature of the annealing treatment of S28 is low, the diffusion of hydrogen implanted into the high concentration hydrogen region 40 is suppressed. In this case, at the time of completion of the semiconductor device 10, the state where the hydrogen concentration in the high concentration hydrogen region 40 is higher than 1.0 × 10¹⁵/cm² may be maintained.

In the flow of Fig. 12, the order of the steps S22 to S28 may be reversed. For example, the formation of the interlayer dielectric 28 in S22 may be executed after the formation of the back surface metal electrode layer (drain electrode 32) in S24. In addition, the formation of the back surface metal electrode layer (drain electrode 32) in S24 may be executed after the step S26 or after the step of S28.

In the above-described embodiment, the case where the semiconductor device 10 is a MOSFET has been described. The present embodiment is applicable to a SiC semiconductor device other than a MOSFET as long as the SiC semiconductor device has a structure where a substrate, a buffer layer, and a drift layer are stacked. For example, the semiconductor device 10 may be a transistor such as a junction field effect transistor (JFET), a bipolar junction transistor (BJT), or an insulated gate bipolar transistor (IGBT), or may be a diode such as a Schottky barrier diode or a PIN diode.

The present invention has been described hereinbefore based on the examples. It will be understood by those skilled in the art that the present invention is not limited to the above-described embodiment, and that various modifications are possible, and such modifications are also within the scope of the present invention.

### Industrial Applicability

According to one aspect of the present invention, expansion of a stacking fault during current application to a SiC semiconductor device can be suppressed.

### Reference Signs List

- 10: semiconductor device
- 12: substrate
- 12a: first surface
- 12b: second surface
- 14: buffer layer
- 16: drift layer
- 40: high concentration hydrogen region

## Claims

1. A method for manufacturing a semiconductor device including a substrate formed of silicon carbide and a semiconductor layer of a first conductivity type provided on a first surface of the substrate, the method comprising:
irradiating the semiconductor device with hydrogen ions to form a high concentration hydrogen region having a hydrogen concentration of higher than 10¹⁵/cm³ over a thickness of 1 µm or more,
wherein at least a part of the high concentration hydrogen region is formed in the semiconductor layer of the first conductivity type.

2. The method for manufacturing a semiconductor device according to claim 1,
wherein at least a part of the high concentration hydrogen region is formed within 5 µm from the first surface.

3. The method for manufacturing a semiconductor device according to claim 1,
wherein the semiconductor layer of the first conductivity type includes a buffer layer provided on the substrate and a drift layer of the first conductivity type provided on the buffer layer and having a lower impurity concentration than the buffer layer, and
at least a part of the high concentration hydrogen region is formed in the buffer layer.

4. The method for manufacturing a semiconductor device according to claim 3,
wherein at least a part of the high concentration hydrogen region is formed in an interface between the substrate and the buffer layer.

5. The method for manufacturing a semiconductor device according to claim 1,
wherein the semiconductor layer of the first conductivity type includes a buffer layer provided on the substrate and a drift layer of the first conductivity type provided on the buffer layer and having a lower impurity concentration than the buffer layer, and
at least a part of the high concentration hydrogen region is formed in the drift layer.

6. The method for manufacturing a semiconductor device according to claim 1,
wherein the semiconductor layer of the first conductivity type includes a buffer layer provided on the substrate and a drift layer of the first conductivity type provided on the buffer layer and having a lower impurity concentration than the buffer layer, and
the high concentration hydrogen region is formed across the buffer layer and the drift layer.

7. The method for manufacturing a semiconductor device according to any one of claims 1 to 6,
wherein a peak value of the hydrogen concentration in the high concentration hydrogen region is 10¹⁶/cm³ or higher.

8. The method for manufacturing a semiconductor device according to any one of claims 1 to 7,
wherein the hydrogen concentration in the high concentration hydrogen region is 10²⁰/cm³ or lower.

9. The method for manufacturing a semiconductor device according to any one of claims 1 to 8,
wherein a dose of the hydrogen ions is 10¹²/cm² or higher.

10. The method for manufacturing a semiconductor device according to claim 9,
wherein the dose of the hydrogen ions is 10¹⁶/cm² or lower.

11. The method for manufacturing a semiconductor device according to any one of claims 1 to 10, further comprising:
irradiating the semiconductor layer with impurity ions of a second conductivity type different from the first conductivity type; and
annealing the semiconductor layer at a temperature of 1500°C or higher to activate the impurity of the second conductivity type,
wherein the irradiation with the hydrogen ions is executed before the annealing at the temperature of 1500°C or higher.

12. The method for manufacturing a semiconductor device according to any one of claims 1 to 11, further comprising:
forming a metal electrode layer on a second surface of the substrate opposite to the first surface; and
annealing the metal electrode layer at a temperature of 450°C or higher and 800°C or lower,
wherein the irradiation with the hydrogen ions is executed before the annealing at the temperature of 450°C or higher and 800°C or lower.

13. A semiconductor device comprising:
a substrate formed of silicon carbide;
a semiconductor layer of a first conductivity type provided on the substrate; and
a high concentration hydrogen region having a hydrogen concentration of higher than 10¹⁵/cm³ over a thickness of 1 µm or more,
wherein at least a part of the high concentration hydrogen region is formed in the semiconductor layer of the first conductivity type.
